(19) Europäisches Patentamt

European Patent Office

Office européen des brevets

(11) EP 1 634 978 A1

(12) **EUROPÄISCHE PATENTANMELDUNG**

(43) Veröffentlichungstag:
**15.03.2006 Patentblatt 2006/11**

(51) Int Cl.:
*C23C 14/06* (2006.01)  *C23C 14/00* (2006.01)
*F01L 1/16* (2006.01)

(21) Anmeldenummer: **05017831.8**

(22) Anmeldetag: **17.08.2005**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **09.09.2004 DE 102004043550**

(71) Anmelder: **INA-Schaeffler KG**
**91074 Herzogenaurach (DE)**

(72) Erfinder:
• **Hosenfeldt, Tim Matthias**
 **96106 Ebern (DE)**
• **Grell, Karl-Ludwig**
 **91086 Aurachtal (DE)**

(54) **Verschleissfeste Beschichtung und Verfahren zur Herstellung derselben**

(57) Die vorliegende Erfindung betrifft ein Verfahren zur Herstellung einer verschleißfesten Beschichtung und eine verschleißfeste Beschichtung auf vorbestimmten Flächen von einem reibenden Verschleiß ausgesetzten Maschinenteilen für insbesondere Verbrennungskraft- maschinen, bestehend aus mindestens einer nanokristallinen Funktionsschicht (4) aus mindestens zwei $CrN_x$-Phasen für eine Reibungsreduzierung und für eine Erhöhung des Verschleißwiderstandes der vorbestimmten Fläche (2) des Maschinenteils (1).

Fig. 4

**EP 1 634 978 A1**

**Beschreibung**

Die vorliegende Erfindung bezieht sich auf eine verschleißfeste Beschichtung auf vorbestimmten Flächen von einem reibenden Verschleiß ausgesetzten Maschinenteilen und auf ein Verfahren zur Herstellung einer derartigen verschleißfesten Beschichtung, insbesondere für Maschinenteile in Verbrennungskraftmaschinen.

Obwohl auf beliebige Maschinenteile anwendbar, werden die vorliegende Erfindung sowie die ihr zugrunde liegende Aufgabe in Bezug auf Maschinenteile für Verbrennungskraftmaschinen, insbesondere in Bezug auf Ventiltriebkomponenten, wie beispielsweise Tassenstößel, näher erläutert.

Es sind Nockenstößelvorrichtungen bekannt, welche in beispielsweise Kraftfahrzeugmotoren mit hin- und hergehenden Kolben eingebaut sind, welche Lufteinlass- und Luftauslassventile aufweisen, die sich in Phase mit der Drehung der Kurbelwelle oder synchron hierzu öffnen und schließen. Ein Ventilantriebsmechanismus wird zur Übertragung der Bewegung des an der Nockenwelle angebrachten Nockens auf die Ventile verwendet, wenn sich die Nockenwelle zusammen mit der Kurbelwelle des Motors dreht. Dabei gelangt der Nocken der Nockenwelle in Reibkontakt mit einer Lauffläche des zugeordneten Tassenstößels.

Allgemein unterliegen moderne Ventiltriebkomponenten, wie beispielsweise derartige Tassen- und Pumpenstößel steigenden Anforderungen bezüglich des Verschleißwiderstandes und der Ressourcenschonung. Die Ursachen für die Notwendigkeit eines erhöhten Verschleißwiderstandes liegen in den immer höher werdenden Belastungen und Beanspruchungen des tribologischen Systems, bestehend aus Steuernocken und -stößel. Die Ursachen hierfür liegen in neuen Motorkonzepten, wie beispielsweise Benzin- und Dieseldirekteinspritzsystemen, mit stetig steigenden Einspritzdrücken, einem zunehmenden Anteil an abrasiven Partikeln im Schmierstoff, mangelnder Ölversorgung der Reibpartner, was einen erhöhten Anteil an Mischreibung zur Folge hat, und der zunehmenden Verwendung von tribologisch ungünstigen Stahlnocken zur Kosten- und Massereduzierung. Ein wichtiger Beitrag zur Ressourcenschonung ist die Reduzierung der Reibungsverluste im Ventiltrieb, mit daraus folgender Kraftstoffeinsparung bei gleichzeitiger Erhöhung der Lebensdauer des gesamten Ventiltriebes. Um die Reibungsverluste effektiv zu reduzieren, ist es notwendig, das Reibmoment über einen breiten Drehzahlbereich zu senken.

Es ist bekannt, derartige Tassenstößel als Leichtmetallstößel für die Ventilsteuerung eines Verbrennungsmotors auszubilden, welcher einen Stößelgrundkörper und eine an der Berührungsfläche für die Steuernocken der Ventilsteuerung eingelegte Stahlplatte mit einer gehärteten Oberfläche aufweist.

Nachteilig an diesem Ansatz hat sich jedoch die Tatsache herausgestellt, dass derartige Tassenstößel im Betriebsfall relativ großen Temperaturschwankungen von -30°C bei Kaltstart bis zu ca. 130°C während des Betriebes einer Brennkraftmaschine ausgesetzt sind. Problematisch dabei ist die möglicherweise unterschiedliche Wärmeausdehnung der verwendeten Werkstoffe. Zwar weist die als verschleißfeste Einlage in einen Leichtmetallstößel eingelegte Stahlplatte gute Verschleißeigenschaften auf, jedoch neigt sie bei entsprechender thermischer Belastung zum Ablösen. Die thermische Belastbarkeit ist deshalb begrenzt. Ein weiterer anwendungstechnischer Nachteil besteht darin, dass der Bauraum in Form eines relativ breiten Randes als Funktionsfläche bzw. als Nockenkontaktfläche, die von dem Steuernocken einer Ventilsteuerung kontaktiert wird, verloren geht.

Nach einem Ansatz gemäß dem Stand der Technik ist es ebenfalls bekannt, Laufflächen von auf reibendem Verschleiß ausgesetzten Maschinenteilen mit Verschleißschutzschichten zu versehen, die je nach Anwendungsfall bevorzugt aus galvanisch aufgetragenen Metallen oder aus in einem thermischen Spritzverfahren aufgetragenen Metallen und/oder Metalllegierungen mit gegebenenfalls Hartstoffzusätzen bestehen.

An diesem Ansatz hat sich jedoch die Tatsache als nachteilig herausgestellt, dass thermisch aufgespritzte Metallschichten eine relativ schwache Festigkeit besitzen, und es ist daher bekannt, zur Verbesserung der Festigkeit die Metallschichten nach dem Auftrag durch beispielsweise Plasmastrahlen, Laserstrahlen, Elektronenstrahlen oder durch einen Lichtbogen derart umzuschmelzen, dass sich die Spritzwerkstoffe mit dem dabei gleichzeitig im Oberflächenbereich aufgeschmolzenen Grundwerkstoff schmelzflüssig vermischen und legieren. Beim Umschmelzlegieren entstehen jedoch inhomogene Zonen unterschiedlicher Zusammensetzung, in denen sowohl der Grundwerkstoff als auch das Schichtmaterial überwiegen kann. Bei zu hohem Grundmaterialanteil ist der Schichtverschleiß dann zu hoch, und bei geringem Grundmaterialanteil besteht bei verschiedenen Schichtkombinationen die Gefahr von Makrorissbildungen, sodass solche Schichten nicht einsetzbar sind. In einem derartigen Fall können Reibungsbelastungen einen unerwünschten Adhäsiv-Verschleiß an den Schichten verursachen.

Ferner ist der Anmelderin der Ansatz bekannt, die Lauffläche des Tassenstößels mittels eines thermochemischen Prozesses zu carbonitrieren und/oder zu nitrocarburieren. An diesem Ansatz hat sich jedoch die Tatsache als nachteilig herausgestellt, dass kein zufriedenstellender Reibungskoeffizient erreicht wird und ein zu geringer Verschleißwiderstand entsteht.

Ferner ist der Anmelderin bekannt, die Lauffläche des Stößels mit einer Manganphosphatschicht oder einem Gleitlack zu beschichten. Auch hierbei werden keine zufriedenstellenden Reibungskoeffizienten und Verschleißwiderstände erreicht. Zudem wird durch derartige Materialien die Umwelt unnötig belastet. Das selbe gilt für galvanische Schichten, die ebenfalls auf den Laufflächen aufgebracht werden können.

Ferner sind im Stand der Technik als Beschichtungsmaterialien Hartmetalle und Schnellarbeitstahle (ASP 23) bekannt, die jedoch neben einem nicht zufriedenstellenden Reibungskoeffizienten und einem nicht zufriedenstellenden Verschleißwiderstand zusätzlich eine nachteilige hohe Masse aufweisen. Ferner ist eine Fertigung derselben lediglich mit einem hohen Fertigungsaufwand verbunden.

Der Anmelderin sind zusätzlich harte, mittels beispielsweise eines PVD- oder eines (PA)CVD-Verfahrens, hergestellte Schichten, wie beispielsweise TiN, CrN, (Ti, Al)N, bekannt. Nachteilig an diesem Ansatz hat sich jedoch die Tatsache herausgestellt, dass diese Schichten einen hohen Verschleiß des Gegenkörpers zur Folge haben, falls diese Schichten nicht nachbearbeitet werden. Im Falle einer Nachbearbeitung ergeben sich undefinierte Oberflächenzustände aufgrund der reaktiven Oberflächen.

Aus dem US-Patent 5,237,967 sind kohlenstoffbasierte PVD- und (PA)CVD-Schichten mit 20 bis 60 Atom-% Wasserstoff in der Deckschicht bekannt, sogenannte metallhaltige Kohlenwasserstoffschichten (Me-C:H) und amorphe Kohlenwasserstoffschichten (a-C:H). Diese Schichten weisen jedoch einen zu geringen Verschleißwiderstand und eine geringe chemische Stabilität auf. Ferner besitzen sie einen zu hohen Flüssigkeitsreibungskoeffizienten, da sie keine Reibungsreduzierung im ölgeschmierten Zustand gewährleisten.

Wie oben bereits erläutert, ist eine Reibungsreduzierung im Ventiltrieb ein notwendiger Beitrag zur Kraftstoffeinsparung und Ressourcenschonung. Dieses Ziel kann erreicht werden, indem man das Gebiet der Festkörper- und Mischreibung reduziert und somit das Gebiet der Flüssigkeitsreibung mit vollständiger Materialtrennung erhöht. Dies erreicht man durch eine möglichst geringe Gesamtrauheit $R_{Ges}$ des tribologischen Systems bestehend aus Tassenstößel und Nockenwelle. Die Gesamtrauheit $R_{Ges}$ ergibt sich durch folgende Gleichung:

$$R_{Ges} = ((R_{Tassenstößel})^2 + (R_{Nockenwelle})^2)^{0,5} \quad ,$$

wobei $R_{Tassestößel}$ die Oberflächenrauheit des Tassenstößels und $R_{Nockenwelle}$ die Oberflächenrauheit der Nockenwelle darstellen.

Um die hierfür notwendige geringe Rauheit des Tassenstößels über die gesamte Lebensdauer zu erhalten, ist es notwendig, die Oberfläche so zu gestalten, dass sie einen hohen Verschleißwiderstand, eine geringe adhäsive Neigung zum Gegenkörper und geringe Reaktivität zur Umgebung aufweist. Ferner darf die Oberfläche vorzugsweise keine abrasiven Partikel, wie Droplets, enthalten.

Die Tassenstößel aus Eisenkohlenstofflegierungen, auch im wärmebehandelten Zustand, wie carbonitriert, nitrocarburiert oder nitriert, erreichen nicht die hierfür notwendigen Verschleißwiderstände und tribologisch günstigen Oberflächenzustände. Behandelt man beispielsweise Nitridschichten, insbesondere durch (Fein)Schleifen, Läppen, Polieren, Strahlen, etc., mechanisch nach, so werden neben der Oberflächenstruktur auch die chemische Zusammensetzung und Reaktivität der Oberfläche verändert. Diese Veränderungen sind zum einen großen Streuungen unterworfen, wodurch keine gleich bleibende Qualität realisiert werden kann. Zum anderen weisen topographisch affine Oberflächen ungünstigere tribologische Eigenschaften auf und neigen zu Adhäsionen mit dem Gegenkörper. Ferner werden durch Schleif- und Polierprozesse Druckeigenspannungen in den oberflächennahen Bereichen induziert, welche sich zu den bereits vorhandenen hohen Druckeigenspannungen der Hartstoffschicht addieren.

Zusätzlich führen die induzierten Versetzungen und die herausgerissenen Droplets zu Fehlstellen und Mikrorissen, sodass die lokale Dauerfestigkeit der Schicht bei Tassenstößeln reduziert und die Haftfestigkeit bis hin zum möglichen Abplatzen beim Nachbearbeiten der Schicht herabgesetzt wird.

Verzichtet man jedoch beispielsweise bei den mit einem Lichtbogenverfahren abgeschiedenen Schichten auf ein nachträgliches Polieren, führen die harten Droplets zu abrasivem Verschleiß des Gegenkörpers oder zumindest zu einem regellosen Polieren des Gegenkörpers, wodurch sich nicht abzusehende nachteilige Folgen ergeben. Darüber hinaus brechen die Droplets während des Betriebes aus der Schicht heraus, was zu einer Schichtschädigung und zu freien, abrasiv wirkenden Partikeln führt.

Somit liegt der vorliegenden Erfindung die Aufgabe zugrunde, eine Beschichtung sowie ein Herstellungsverfahren für eine derartige Beschichtung zu schaffen, welche die oben genannten Nachteile beseitigten und insbesondere das Reibmoment im gesamten Einsatzbereich reduziert und die Lebensdauer des beschichteten Maschinenteils sowie des Gegenkörpers erhöht.

Erfindungsgemäß wird diese Aufgabe vorrichtungsseitig durch eine verschleißfeste Beschichtung mit den Merkmalen des Patentanspruchs 1 und verfahrensseitig durch ein Verfahren mit den Merkmalen des Patentanspruchs 17 gelöst.

Die der vorliegenden Erfindung zugrunde liegende Idee besteht darin, dass die verschleißfeste Beschichtung aus mindestens einer nanokristallinen Funktionsschicht aus mindestens zwei $CrN_x$-Phasen für eine Reibungsreduzierung und für eine Erhöhung des Verschleißwiderstandes der vorbestimmten Fläche des Maschinenteils besteht.

Somit weist die vorliegende Erfindung gegenüber den bekannten Ansätzen gemäß dem Stand der Technik den Vorteil auf, dass der Reibungskoeffizient erheblich reduziert und die Lebensdauer des beschichteten Maschinenteils sowie des zugeordneten Gegenkörpers erhöht werden. Ferner kann die Beschichtung derart ausgeführt werden, dass es zu keiner Ausbildung von Droplets und zu keiner Zunahme der Oberflächenrauheit kommt. Ferner werden im Vergleich zu wärmebehandelten Oberflächen deutlich höhere Härtewerte erreicht. Somit wird eine geringere adhäsive Neigung zum Gegenkörper und eine verbesserte Trennung vom Gegenkörper gewährleistet. Durch die $CrN_x$-Mischphasen der Beschichtung kann eine optimierte chemische Zusammensetzung, eine optimierte Mikrostruktur und eine optimierte Morphologie erreicht werden.

In den Unteransprüchen finden sich vorteilhafte Ausgestaltungen und Verbesserungen der im Patentanspruch 1 angegebenen verschleißfesten Beschichtung sowie des im Patentanspruch 17 angegebenen Verfahrens.

Gemäß einer bevorzugten Weiterbildung besteht die mindestens eine Funktionsschicht aus einer metastabilen Mischphase aus überwiegend $Cr_2N$ und CrN. Der Anteil an $Cr_2N$ in der metastabilen Mischphase beträgt vorzugsweise mindestens 70%. Durch Bildung einer derartigen metastabilen Mischphase zwischen dem $Cr_2N$- und dem CrN-Gitter, die nanokristallin vorliegen, werden günstige tribologische und mechanische Eigenschaften des Schichtsystems erhalten. Die Funktionsschicht wird vorzugsweise durch eine geeignete Mischphase optimiert. Vorteilhaft weist die mindestens eine Funktionsschicht eine Korngröße im Bereich von 10 nm auf. Durch die geringe Korngröße und der Mischphase aus überwiegend $Cr_2N$ und geringen Anteilen von CrN weisen die nanokristallinen Schichten weniger Defekte und einen deutlich geringeren Rauheitszuwachs auf. Die nanokristalline Struktur führt ferner zu einer Abnahme der Versetzungsdichte, wodurch eine Rissbildungsgefahr herabgesetzt wird. Darüber hinaus dienen die geringen Korngrenzen als wirkungsvolle Rissbarrieren, da aufgrund der Korngrößen von etwa 10 nm die maximalen Risslängen ebenfalls etwa nur 10 nm betragen. Somit ist der Spannungsintensitätsfaktor an der Rissspitze beim Erreichen der Korngrenze derart gering, dass die Korngrenze nicht überwunden werden kann, wodurch keine Rissausbreitung erfolgen kann.

Gemäß einem weiteren bevorzugten Ausführungsbeispiel weist die mindestens eine Funktionsschicht Härtewerte zwischen 2.500 HV und 3.200 HV auf. Somit wird der Verschleißschutz des beschichteten Körpers im Vergleich zu wärmebehandelten Oberflächen deutlich vergrößert, eine adhäsive Neigung zum Gegenkörper verringert und eine Trennung von dem Gegenköper durch einen Schmierfilm verbessert. Für bestimmte Anwendungen kann die Härte der Deckschicht zum Schonen des Gegenkörpers im Reibkontakt auf geringere Härtewerte bis zu 1.600 HV reduziert werden.

Gemäß einem weiteren bevorzugten Ausführungsbeispiel weist die mindestens eine Funktionsschicht einen Mittenrauwert $R_a$ von maximal 0,04 $\mu$m auf. Durch einen derartig geringen Oberflächenrauheitswert und der erhaltenen Topographie mit charakteristischen positiven Materialanteilen und flachen Böschungswinkeln bzw. -hügeln kommt es zu einer sanften Glättung des Gegenkörpers und somit zu einer Abnahme der Gesamtrauheit $R_{Ges}$ des tribologischen Systems, bestehend aus beispielsweise Tassenstößel und Gegenkörper. Durch die geringe Gesamtrauheit $R_{Ges}$ verschiebt sich die Striebeckkurve nach links, sodass es zu einer Abnahme der Reibungszustände mit Festkörperkontakt und somit der verschleißkritischen Zustände und der Reibung kommt. Der hohe Verschleißwiderstand und die hohe Härte führen zusätzlich zu einer Aufrechterhaltung der glatten Oberfläche und der Schichtdicke während eines reibbehafteten Betriebes.

Vorzugsweise besteht die mindestens eine Funktionsschicht aus mehreren nanokristallinen Einzelschichten aus mindestens zwei $CrN_x$-Phasen, wobei die einzelnen Schichten graduell oder in gleich bleibender Schichtzusammensetzung aufbringbar sind.

Gemäß einem weiteren bevorzugten Ausführungsbeispiel ist zwischen der vorbestimmten Fläche des Maschinenteils und der tetraedrischen amorphen Kohlenstoffschicht mindestens eine Stützschicht und/oder mindestens eine Haftvermittlungsschicht vorgesehen, welche beispielsweise mittels eines PVD-Verfahrens als metallhaltige, beispielsweise Wolfram umfassende, Kohlenstoffschicht, Carbide und/oder Nitride der Übergangsmetalle aufweisende Schicht, mittels einer Wärmebehandlung als einsatz-gehärtete, carbonitrierte oder nitrocarburierte Schicht, mittels eines thermochemischen Verfahrens als nitrierte oder borierte Schicht und/oder beispielsweise mittels eines galvanischen Verfahrens als Chrom aufweisende Schicht ausgebildet ist. Vorzugsweise weist die mindestens eine Stützschicht und/oder Haftvermittlungsschicht jeweils eine Dicke von 0,1 $\mu$m bis 4,0 $\mu$m auf, wobei die Dicke wiederum jeweils an die entsprechenden Anforderungen bzw. an die Kundenwünsche anzupassen ist.

Beispielsweise besteht die vorbestimmte Fläche des Maschinenteils aus 16MnCr5, C45, 100Cr6, 31 CrMoV9, 80Cr2 oder dergleichen.

Vorteilhafte Verwendungen der erfindungsgemäßen Beschichtungen stellen eine Gegenläuferschicht auf einem als Tassenstößel, Schlepp- oder Kipphebel ausgebildeten Gegenläufer bei Verbrennungskraftmaschinen, die Nokkenkontaktfläche oder die Nockenkontaktfläche und/oder das Tassenhemd des Tassenstößels, vorbestimmte Oberflächen von Ventiltriebkomponenten, insbesondere von mechanischen und hydraulischen Tassenstößeln, von hydraulischen Abstütz- und Einsteckelementen, von Ventilschäften bzw. Ventilschaftauflagen, von Wälzlagerkomponenten, von Steuerkolben, von Ausrücklagern, von Kolbenbolzen, von Lagerbuchsen, von Linearführungen oder dergleichen dar. Dabei können vorteilhaft lediglich bestimmte Flächen der einzelnen Maschinenteile oder die vollständigen Oberflächen der Maschinenteile mit einer erfindungsgemäßen Beschichtung ausgebildet werden.

Die vorbestimmte Fläche des Maschinenteils weist vorzugsweise einen Mittenrauwert $R_a$ von maximal 0,03

μm auf. Dies kann beispielsweise durch eine geeignete Bearbeitung des Grundkörpers vor dem Beschichten eingestellt werden.

Gemäß einem weiteren bevorzugten Ausführungsbeispiel wird die mindestens eine nanokristalline Funktionsschicht mittels eines PVD-Verfahrens, vorzugsweise mittels eines reaktiven PVD-Sputterverfahrens, auf der vorbestimmten Fläche des Maschinenteils abgeschieden. Dabei kann vorteilhaft zusätzlich eine Subplantation von Kohlenstoff in die mindestens eine Funktionsschicht erfolgen. Vorteilhaft wird die Abscheidung der mindestens einen Funktionsschicht mit einer Beschichtungstemperatur durchgeführt, welche kleiner ist als die Anlasstemperatur des Maschinenteils.

Gemäß einem weiteren bevorzugten Ausführungsbeispiel wird keine mechanische Nachbearbeitung der mindestens einen abgeschiedenen Funktionsschicht durchgeführt. Dadurch können geringe Oberflächenrauheitswerte beibehalten werden, wodurch das Reibmoment zusätzlich verringert wird. Ebenfalls erfolgt vorzugsweise keine Nachwärmebehandlung des Maschinenteils, sodass an ursprünglich erreichten Eigenschaften der abgeschiedenen Beschichtung keine Änderungen während etwaiger Nachbearbeitungen auftreten.

Die Erfindung wird im folgenden anhand von Ausführungsbeispielen unter Bezugnahme auf die beiliegenden Figuren der Zeichnung näher erläutert. Von den Figuren zeigen:

Figur 1    eine Vorderansicht einer Reibpaarung, bestehend aus Tassenstößel und Nockenwelle für den Betrieb eines Ventils einer Brennkraftmaschine;

Figur 2    eine perspektivische Ansicht des Tassenstößels aus Figur 1;

Figur 3    eine perspektivische Ansicht eines hydraulischen Abstützelementes, welches über eine Wälzlagerkomponente mit einem Schlepphebel in Verbindung steht; und

Figur 4    eine schematische Querschnittsansicht eines Maschinenteils mit verschleißfester Beschichtung gemäß einem Ausführungsbeispiel der vorliegenden Erfindung.

In den Figuren der Zeichnung bezeichnen gleiche Bezugszeichen gleiche oder funktionsgleiche Komponenten, soweit nichts Gegenteiliges angegeben ist.

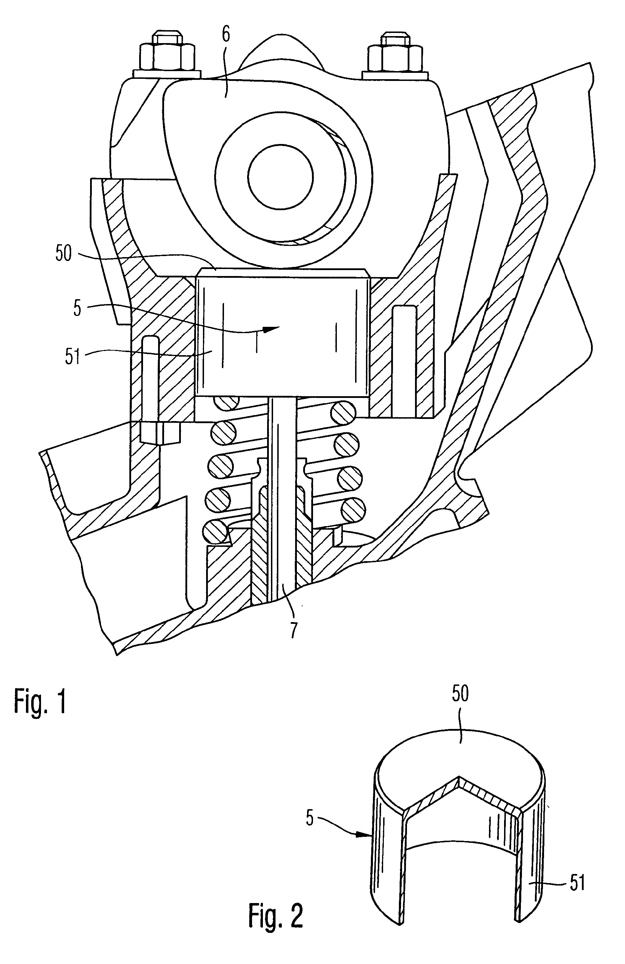

Fig. 1 illustriert eine Reibpaarung, bestehend aus einem Tassenstößel 5 mit einer Nockenkontaktfläche 50 und einem Tassenhemd 51 sowie aus einer Nocke 6. Der Tassenstößel 5 ist in Fig. 2 in einer perspektivischen Ansicht detaillierter dargestellt. Der Tassenstößel 5 ist im allgemeinen für Maschinenteile in Brennkraftmaschinen mit dem Schaft 7 eines Ventils verbunden, welches durch Anlage der Nockenfläche mit der Nockenkontaktfläche 50 des Tassenstößels 5 das Ventil öffnet oder schließt.

Im allgemeinen unterliegen moderne Ventiltriebkomponenten, wie beispielsweise Tassen- und Pumpenstößel, hohen Anforderungen bezüglich des Verschleißwiderstandes und der Ressourcenschonung, insbesondere an der Kontaktfläche 50.

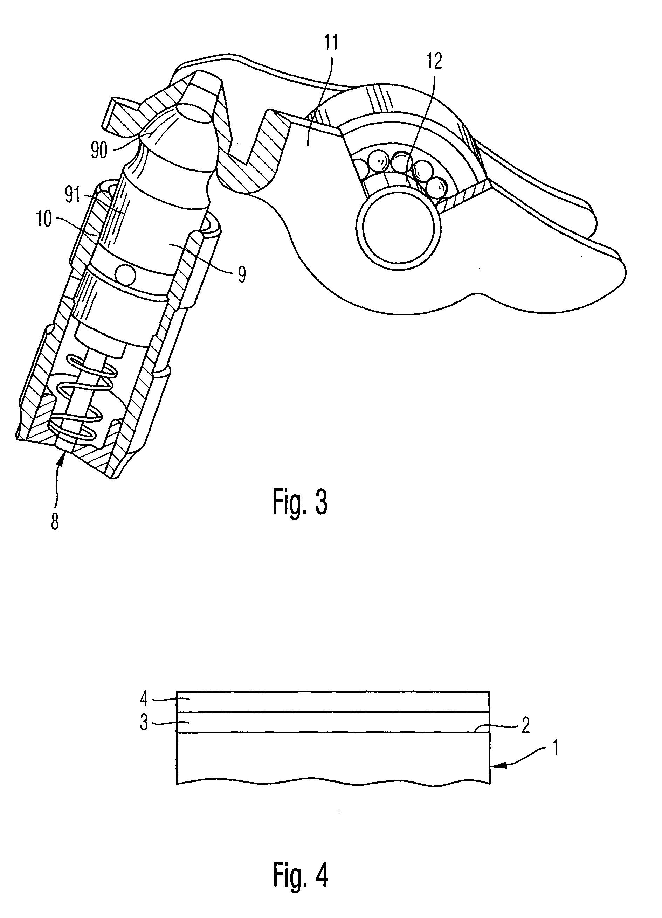

In Verbindung mit Fig. 4, welche eine schematische Querschnittsansicht einer verschleißfesten Beschichtung für ein Maschinenteil 1, beispielsweise für einen Tassenstößel 5, gemäß einem bevorzugten Ausführungsbeispiel der vorliegenden Erfindung illustriert, wird ein Ausführungsbeispiel der vorliegenden Erfindung im folgenden näher erläutert.

Der Tassenstößel 5 wird für eine Reduzierung des Reibungskoeffizienten und für eine Erhöhung des Verschleißwiderstandes im Bereich der Nockenkontaktfläche 50 oder bei Bedarf im Bereich der Nockenkontaktfläche 50 und des Tassenhemdes 51 mit einer erfindungsgemäßen verschleißfesten Beschichtung beschichtet. Im Falle hoher Verformungen des Tassenhemdes 51 des Tassenstößels 50 im Bereich der offenen Seite, kann wahlweise auch eine Teilbeschichtung des Tassenhemdes 51, eine ausschließliche Beschichtung der Nockenkontaktfläche 50 oder ein nachträgliches zumindest teilweises Entfernen der reibfesten Beschichtung im Bereich des Tassenhemdes 51 des Tassenstößels 5 erfolgen.

Im vorliegenden Fall gilt zunächst die Annahme, dass die Nockenkontaktfläche 50 des Tassenstößels 5 als vorbestimmte Fläche 2 des Maschinenteils angesehen wird. Es ist für einen Fachmann offensichtlich, dass beliebige vorbestimmte Flächen beliebiger Maschinenteile mit der erfindungsgemäßen Beschichtung beschichtet werden können.

Die vorbestimmte Fläche 2, d.h. vorliegend die Nockenkontaktfläche 50 des Tassenstößels 5, wird vorzugsweise vor einem Beschichten einsatzgehärtet oder carbonitriert und eingelassen.

Der Grundkörper, im vorliegenden Fall die Nockenkontaktfläche 50 des Tassenstößels 5, welcher vorteilhaft aus einem kostengünstigen Stahlwerkstoff, wie beispielsweise 16MnCr5, C45, 100Cr6, 31CrMoV9, 80Cr2 oder dergleichen, besteht, wird gemäß dem vorliegenden Ausführungsbeispiel anschließend mit einer Stützschicht 3 und/oder einer Haftvermittlungsschicht 3 beschichtet. Die Stützschicht 3 bzw. die Haftvermittlungsschicht 3 kann beispielsweise jeweils aus einem metallhaltigen Kohlenstoff, beispielsweise einer Verbindung aus Wolfram und Kohlenstoff, aber auch aus anderen metallischen Stoffen (z.B. Cr, Ti), sowie Boriden, Carbiden und Nitriden der Übergangsmetalle bestehen. Die Stützschicht 3 und/oder die Haftvermittlungsschicht 3 kann beispielsweise durch Wärmebehandlung, beispielsweise Einsatzhärten, Carbonitrieren, Nitrocarburieren, durch ein thermochemisches Verfahren, beispielsweise Nitrieren, Borieren, durch ein galvanisches Verfahren, beispielsweise durch Aufbringen einer chromhaltigen Schicht, oder mittels eines PVD-Verfahrens, beispielsweise Aufbringen von Me-C, Carbiden und Nitriden der Übergangsmetalle, gebildet werden. Bei einem PVD-Verfahren, wie beispielsweise bei der Sputter- oder der ARC-Technologie werden evtl. Metalle verdampft und als Schicht auf das Substrat unter Zugabe von reaktiven Gasen (z.B. Stickstoff) aufgebracht. Chrom wird dabei als festes Ausgangsmaterial verdampft und mittels Anreicherung mit Stickstoffatomen durch Einbringen einer hohen Energie auf die vorbestimmte Fläche 2 des Tassenstößels 5 als teilkristalline Schicht abgeschieden.

Es sei an dieser Stelle darauf hingewiesen, dass lediglich eine Stützschicht 3 oder eine Haftvermittlungsschicht 3, mehrere Stützschichten 3 bzw. mehrere Haftvermittlungsschichten 3 oder eine Kombination dieser beiden Schichten auf dem Grundkörper bzw. der vorbestimmten Fläche 2 des Tassenstößels 5 gebildet werden können. Für den Fall, dass eine Haftverbesserung der noch zu bildenden verschleißfesten Beschichtung bzw. einer Stützschicht auf dem Grundkörper gewünscht ist, wird eine Schicht als Haftvermittlungsschicht 3 mit einer Dicke von beispielsweise 0,1 $\mu$m bis 2,0 $\mu$m auf dem Grundkörper gebildet. Für den Fall, dass die Schicht jedoch als Stützschicht, d.h. als mechanische Stütze zwischen dem Grundkörper und der noch zu bildenden verschleißfesten Beschichtung dienen soll, sind Dicken von beispielsweise 2,0 $\mu$m bis 4,0 $\mu$m vorteilhaft. Durch die Stützschicht soll die Ermüdungsfestigkeit erhöht werden, d.h. plastische Verformungen, Rissbildungen, -wachstum und Brüche des Schichtsystems verhindert werden. Derartige Ermüdungsvorgänge können durch die Belastung des Nockens und der daraus induzierten Materialbeanspruchung des Tassenstößels 5 unterstützt durch unterschiedliche Härtegrade, Elastizitätsmodule, Verformbarkeiten der einzelnen Schichten bzw. des Grundkörpers und der verschleißfesten Beschichtung entstehen. In diesem Fall ist eine Ausbildung der Schicht 3 als Stützschicht 3 entweder alleine oder in Kombination mit einer geeigneten Haftvermittlungsschicht vorzuziehen.

Wie in Fig. 4 dargestellt ist, wird gemäß dem vorliegenden Ausführungsbeispiel nach einem Bilden der Stütz- und/oder der Haftvermittlungsschicht 3 eine verschleißfeste Beschichtung 4 darauf gebildet. Die verschleißfeste Beschichtung 4 besteht vorzugsweise aus einer nanokristallinen Funktionsschicht 4 aus mindestens zwei CrN$_x$-Phasen oder mehreren derartiger Funktionsschichten 4. Die zu beschichtenden Oberflächen werden mittels beispielsweise einem reaktiven PVD-Sputterverfahren mit nanokristallinen Schichten aus CrN$_x$-Phasen beschichtet, wobei die Schichten jeweils aus einer metastabilen Mischphase aus überwiegend Cr$_2$N-Bindungen besteht. Der Anteil der Cr$_2$N-Bindungen beträgt vorzugsweise über 70%, sodass der Anteil an Cr(N)-Bindungen folglich weniger als 30% beträgt.

Die maximale Beschichtungstemperatur beträgt vorzugsweise 260°C, sodass bei einem Beschichtungsvorgang das Grundmaterial nicht angelassen wird.

Beim Beschichtungsverfahren wird beispielsweise in einer Beschichtungskammer Chrom verdampft und ein Stickstoffgas in die Beschichtungskammer als Reaktivgas eingeleitet, ionisiert und auf die zu beschichtende Oberfläche beschleunigt. Dabei erfolgt gleichzeitig eine Verbindung mit den beispielsweise durch Argonionen herausgeschlagenen Chromionen. Die herausgeschlagenen Chromionen verbinden sich mit dem eingeleiteten Stickstoff und werden auf die zu beschichtende Oberfläche mittels einer an die zu beschichtenden Bauteile angelegten Bias-Spannung gelenkt. Die Cr$_2$N-Bindungen bestehen beispielsweise aus 70% Chrom und 30% Stickstoff oder weniger. Der Anteil von Cr$_2$N-Bindungen zu CrN-Bindungen beträgt ebenfalls in etwa 70:30. Dieses Verhältnis wird durch mehrere prozessbedingte Parameter bestimmt, wie beispielsweise die an der zu beschichtenden Oberfläche anliegenden Bias-Spannung, dem Argonvolumenstrom, dem Stickstoffvolumenstrom, der Rotationsgeschwindigkeit des zu beschichtenden Maschinenteils in der Beschichtungskammer, dem anliegenden Magnetfeld, etc.

Unter Umständen kann es vorteilhaft sein, Kohlenstoff in die nanokristalline Funktionsschicht 4 mittels einer Subplantation einzubringen, d.h. Kohlenstoffatome werden in die erste Atomlage der nanokristallinen Funktionsschicht 4 mit hoher Energie eingebracht und daran angebunden. Durch eine derartige Subplantation von Kohlenstoff in die nanokristalline Funktionsschicht 4 ergibt sich ein niedrigerer Reibungskoeffizient als bei einer herkömmlichen Chromnitridschicht und ein größerer adhäsiver Verschleißwiderstand.

Die nanokristalline Funktionsschicht 4 kann direkt oder mit der oben erläuterten Stützschicht 3 bzw. Haftvermittlungsschicht 3 auf der vorbestimmten Fläche 2 des Maschinenteils 1 graduell oder in gleich bleibender Schichtzusammensetzung abgeschieden werden. Der Beschichtungsprozess durch das reaktive PVD-Sputtern erfolgt vorzugsweise unterhalb der Anlasstemperatur des wärmebehandelten Bauteils.

Um günstige tribologische und mechanische Eigenschaften des Schichtsystems zu erhalten, wird die nanokristalline Funktionsschicht 4, welche sich im Kontakt mit dem Gegenkörper befindet, bezüglich der chemischen Zusammensetzung, der Mikrostruktur und der Morphologie durch Bildung einer metastabilen Mischphase zwischen dem Cr$_2$N- und dem CrN-Gitter, welche in nanokristallinem Zustand vorliegen, optimiert. Durch eine geringe Korngröße im Bereich von 10 nm und der Mischphase aus überwiegend Cr$_2$N-Bindungen und geringen Anteilen von Cr(N)-Bindungen erhält man bei der röntgenographischen Phasenanalyse eine deutliche Verbreiterung der Interferenzlinien und geringe Intensitäten der Reflexe, da jeweils nur wenige Kristallite so orientiert sind, dass sie die Beugungsgleichung erfüllen. Im Vergleich zu anderen Schichten weisen die nanokristallinen Schichten weniger Defekte und einen deutlich geringeren Rauheitszuwachs auf. Die nanokristalline Struktur führt ferner zu einer Abnahme der Versetzungsdichte, wodurch die Rissbildungsgefahr herabgesetzt wird. Darüber hinaus dienen die Korngrenzen als wirkungsvolle Rissbarriere, da aufgrund der Korngröße von etwa 10 nm die maximalen Risslängen ebenfalls etwa nur 10 nm betragen. Somit ist der Spannungsintensitätsfaktor an der Rissspitze beim Erreichen der Korngrenze derart gering, dass die Korngrenze nicht überwunden werden kann und somit keine Rissausbreitung erfolgen kann.

Die Beschichtung wird vorzugsweise mit einer Dicke von etwa 0,1 $\mu$m bis etwa 4,0 $\mu$m, vorzugsweise 2,0 $\mu$m, ausgebildet. Dadurch ändern sich die Abmessungen und Oberflächenrauheiten in einem derart geringen Maße, dass keine Nachbearbeitung notwendig ist. Der Beschichtungsvorgang ist vorzugsweise derart durchzuführen, dass es zu keiner Ausbildung von Droplets und einer maximalen Zunahme der Rauheit auf einen Mittenrauwert $R_a$ von 0,04 $\mu$m kommt.

Die Nockenkontaktfläche 50 des Stößels 5 wird vorzugsweise nach dem Beschichten nicht weiter nachbearbeitet, um beste tribologische und mechanische Eigenschaften zu sichern. Während der Beschichtung herrscht vorteilhaft ein derart geringer Temperatureintrag, dass es zu keinen Anlasseffekten des Grundmaterials kommt und beispielsweise die unbeschichtete Ventilschaftauflage ohne Nachwärmebehandlung Härtewerte von mindestens 650 HV aufweist. Bedingt durch die Tatsache, dass keine Nachwärmebehandlung des Grundmaterials, besonders der Ventilschaftauflage, vorgenommen wird, wird eine gleich bleibende hohe und reproduzierbare Qualität des Gesamtsystems gewährleistet.

Bedingt durch die Tatsache, dass nach dem Beschichten die beschichtete Oberfläche, beispielsweise die Nockenkontaktfläche 51 nicht mechanisch durch beispielsweise Schleifen, Läppen, Polieren, Strahlen, oder dergleichen nachbearbeitet wird, wird eine robuste Oberfläche hinsichtlich Funktion und Qualität sowie eine fehlstellenarme Oberfläche mit maximalen Mittenrauheitswerten von 0,04 $\mu$m gewährleistet.

Die Beschichtung 4 bzw. 3, 4 gemäß dem vorliegenden Ausführungsbeispiel weist im Vergleich zu wärmebehandelten Oberflächen deutlich höhere Härtewerte von etwa 2.500 HV bis 3.200 HV, eine geringere adhäsive Neigung zum Gegenkörper und eine verbesserte Trennung vom Gegenkörper durch einen Schmierfilm auf. Durch einen geringen Oberflächenrauheitswert von maximal $R_a$ = 0,04 $\mu$m und der erhaltenen Topographie mit den charakteristischen positiven Materialanteilen und flachen Böschungswinkeln bzw. -hügeln, kommt es zu einer sanften Glättung des Gegenkörpers und somit zu einer Abnahme der Gesamtrauheit $R_{Ges}$ des tribologischen Systems, bestehend aus Tassenstößel 5 und Nockenwelle 6. Der hohe Verschleißwiderstand und die hohe Härte führen zu einer Aufrechterhaltung der glatten Oberfläche und der Schichtdicke während der gesamten Lebensdauer des Maschinenteils bzw. der Brennkraftmaschine.

Im Folgenden wird eine weitere vorteilhafte Verwendung der erfindungsgemäßen Beschichtung näher erläutert. Fig. 3 illustriert eine perspektivische Ansicht eines hydraulischen Abstützelementes 8, welches einen Kolben 9 und ein Gehäuse 10 aufweist. Das hydraulische Abstützelement 8 ist mit einem Schlepphebel 11 gekoppelt, wobei der Schlepphebel 11 über ein Wälzlager 12 schwenkbar gelagert ist. Wie in Fig. 3 ferner ersichtlich ist, weist der Kolben 9 einen Kontaktbereich 90 zwischen dem Kolben 9 und dem Schlepphebel 11 auf. Ferner weist der Kolben 9 einen Kontaktbereich 91 zwischen dem Kolben 9 und dem Gehäuse 10 auf. Für eine Reduzierung des Verschleißes im Kontaktbereich 90 zwischen dem Kolben 9 und dem Schlepphebel 11 wird der Kontaktbereich 90 ebenfalls mit einer erfindungsgemäßen nanokristallinen Funktionsschicht 4 bestehend aus CrN$_x$-Mischphasen unter Zwischenschaltung beispielsweise einer Stütz- und/oder Haftvermittlungsschicht beschichtet. Die reibfeste Beschichtung entspricht dabei der in dem ersten Ausführungsbeispiel gemäß den Fig. 1, 2 erläuterten Beschichtung 3, 4.

Ferner kann ebenfalls der Kontaktbereich 91 zwischen dem Kolben 9 und dem Gehäuse 10 mit einer derartigen Beschichtung 3, 4 je nach Anwendung und Fertigungsgstechnologie beschichtet werden. Dadurch wird die Gesamtlebensdauer des dargestellten tribologischen Systems erhöht, wodurch ein Ausfall der einzelnen Maschinenteile während eines Betriebes reduziert und somit insgesamt Kosten eingespart werden können.

Ferner können bestimmte Wälzlagerkomponenten des Wälzlagers 12, beispielsweise der Wälzkörper, die Innen- und Außenringe des Wälzlagers 12, die Wälzlagerkäfige, die Axialscheiben oder dergleichen ebenfalls zur Erhöhung des Verschleißwiderstandes und zur Reibungsreduzierung mit einer oben beschriebenen nanokristallinen Funktionsschicht 4 unter Zwischenschaltung beispielsweise einer Stütz- und/oder Haftvermittlungsschicht 3 beschichtet werden.

Das oben beschriebene Schichtsystem ist selbstverständlich auch für andere Bau- und Funktionseinheiten, wie beispielsweise Ventilschäfte bzw. Ventilschaftauflagen, Abstütz- und Einsteckelemente, Wälzlagerkomponenten, Ausrücklager, Kolbenbolzen, Lagerbuchsen, Steuerkolben für beispielsweise Einspritzdüsen im Motorenbereich, Linearführungen und andere mechanisch und tribologisch hoch beanspruchte Teile geeignet.

Es sei an dieser Stelle darauf hingewiesen, dass die nanokristalline Funktionsschicht 4 auch direkt auf dem Grundkörper des zu beschichtenden Maschinenteils abgeschieden werden kann, ohne dass eine Stützschicht 3 bzw. Haftvermittlungsschicht 3 dazwischen aufgebracht ist.

Somit schafft die vorliegende Erfindung eine verschleißfeste Beschichtung sowie ein Verfahren zur Herstellung einer derartigen verschleißfesten Beschichtung, wodurch der Verschleißwiderstand von einem reibenden Verschleiß ausgesetzten Maschinenteilen erhöht und zu hohe Reibmomente zwischen diesen Maschinenteilen und entsprechenden Gegenkörpern verhindert werden. Durch die etwa 0,1 $\mu$m bis 4,0 $\mu$m dicke Beschichtung 4 bzw. 3, 4 bleiben die Maße und Oberflächenrauhigkeiten nahezu unverändert, wobei dennoch die Oberfläche reaktiv homogenisiert wird. Die tribologischen Eigenschaften der Schicht werden verbessert und die mechanischen Beanspruchungen werden mit dem Grundkörper geteilt, der aufgrund der Aufgabenstellung und der geringen Beschichtungstemperatur, welche kleiner als 260°C ist, auf kostengünstigen Stählen gefertigt werden kann. Dadurch sind gängige und kostengünstige Fertigungstechnologien einsetzbar.

Obwohl die vorliegende Erfindung anhand bevorzugter Ausführungsbeispiele vorstehend beschrieben wurde, ist sie darauf nicht beschränkt, sondern auf vielfältige Weise modifizierbar.

Es sei an dieser Stelle darauf hingewiesen, dass die obigen Ausführungen auch mit kohlenstoffhaltigen Funktionsschichten (Me-C:H, a-C:H, a-C:H:a, ta-C) realisiert werden können.

**Bezugszeichenliste**

| | |
|---|---|
| 1 | Maschinenteil |
| 2 | vorbestimmte Fläche des Maschinenteils |
| 3 | Stützschicht/Haftvermittlungsschicht |
| 4 | nanokristalline Funktionsschicht/ $CrN_x$-Phasen-Schicht |
| 5 | Tassenstößel |
| 6 | Nocke |
| 7 | Ventilschaft |
| 8 | hydraulisches Abstützelement |
| 9 | Kolben |
| 10 | Gehäuse |
| 11 | Schlepphebel |
| 12 | Wälzlager |
| 50 | Nockenkontaktfläche |
| 51 | Tassenhemd |
| 90 | Kontaktbereich zwischen Kolben und Schlepphebel |
| 91 | Kontaktbereich zwischen Kolben und Gehäuse |

**Patentansprüche**

1. Verschleißfeste Beschichtung (3, 4) auf vorbestimmten Flächen (2) von einem reibenden Verschleiß ausgesetzten Maschinenteilen (1) für insbesondere Verbrennungskraftmaschinen, bestehend aus mindestens einer nanokristallinen Funktionsschicht (4) aus mindestens zwei $CrN_x$-Phasen für eine Reibungsreduzierung und für eine Erhöhung des Verschleißwiderstandes der vorbestimmten Fläche (2) des Maschinenteils (1).

2. Verschleißfeste Beschichtung nach Anspruch 1, **dadurch gekennzeichnet, daß** die mindestens eine Funktionsschicht (4) aus einer metastabilen Mischphase aus überwiegend $Cr_2N$-Bindungen und CrN-Bindungen besteht.

3. Verschleißfeste Beschichtung nach Anspruch 2, **dadurch gekennzeichnet, daß** der Anteil an $Cr_2N$-Bindungen in der metastabilen Mischphase mindestens 70% beträgt.

4. Verschleißfeste Beschichtung nach wenigstens einem der vorhergehenden Ansprüche, **dadurch gekennzeichnet, daß** die mindestens eine Funktionsschicht (4) eine Korngröße im Bereich von 10 nm aufweist.

5. Verschleißfeste Beschichtung nach wenigstens einem der vorhergehenden Ansprüche, **dadurch gekennzeichnet, daß** die mindestens eine Funktionsschicht (4) Härtewerte zwischen 2.500 HV und 3.200 HV aufweist.

6. Verschleißfeste Beschichtung nach wenigstens einem der vorhergehenden Ansprüche, **dadurch gekennzeichnet, daß** die mindestens eine Funktionsschicht (4) einen Mittenrauwert $R_a$ von maximal 0,04 $\mu$m aufweist.

7. Verschleißfeste Beschichtung nach wenigstens einem der vorhergehenden Ansprüche, **dadurch gekennzeichnet, daß** die mindestens eine Funktionsschicht (4) eine Dicke von etwa 0,1 $\mu$m bis 4,0 $\mu$m, vorzugsweise 2,0 $\mu$m, aufweist.

8. Verschleißfeste Beschichtung nach wenigstens einem der vorhergehenden Ansprüche, **dadurch gekennzeichnet, daß** die mindestens eine Funktionsschicht (4) aus mehreren nanokristallinen Einzelschichten aus mindestens zwei

CrN$_x$-Phasen besteht, wobei die einzelnen Schichten graduell oder in gleich bleibender Schichtzusammensetzung aufbringbar sind.

9. Verschleißfeste Beschichtung nach wenigstens einem der vorhergehenden Ansprüche, **dadurch gekennzeichnet, daß** die mindestens eine Funktionsschicht (4) subplantierten Kohlenstoff aufweist.

10. Verschleißfeste Beschichtung nach wenigstens einem der vorhergehenden Ansprüche, **dadurch gekennzeichnet, daß** zwischen der vorbestimmten Fläche (2) des Maschinenteils (1) und der CrN$_x$ Funktionsschicht (4) mindestens eine Stützschicht (3) und/oder mindestens eine Haftvermittlungsschicht (3) vorgesehen ist, welche beispielsweise mittels eines PVD-Verfahrens als metallhaltige, beispielsweise Wolfram umfassende, Kohlenstoffschicht, als Carbide und/oder Nitride der Übergangsmetalle aufweisende Schicht, als mittels einer Wärmebehandlung einsatzgehärtete, carbonitrierte oder nitrocarburierte Schicht, mittels eines thermochemischen Verfahrens als nitrierte oder borierte Schicht, mittels eines galvanischen Verfahrens als Chrom aufweisende Schicht oder dergleichen ausgebildet ist.

11. Verschleißfeste Beschichtung nach Anspruch 10, **dadurch gekennzeichnet, daß** die mindestens eine Stützschicht (3) und/oder die mindestens eine Haftvermittlungsschicht (3) eine Dicke von etwa 0,1 μm bis 4,0 μm aufweist.

12. Verschleißfeste Beschichtung nach wenigstens einem der vorhergehenden Ansprüche **dadurch gekennzeichnet, daß dadurch gekennzeichnet, daß** die vorbestimmte Fläche (2) des Maschinenteils (1) aus 16 MnCr5, C45, 100Cr6, 31CrMoV9, 80Cr2, etc. besteht.

13. Verschleißfeste Beschichtung nach wenigstens einem der vorhergehenden Ansprüche, **dadurch gekennzeichnet, daß** die vorbestimmte Fläche (2) des Maschinenteils (1) einen Mittenrauwert R$_a$ von maximal 0,03 μm aufweist.

14. Verwendung der verschleißfesten Beschichtung (3, 4) nach wenigstens einem der vorhergehenden Ansprüche als Gegenläuferschicht auf einem als Tassenstößel (5), Schlepp- oder Kipphebel (11) ausgebildeten Maschinenteil.

15. Verwendung der verschleißfesten Beschichtung nach Anspruch 14, **dadurch gekennzeichnet, daß** die Nockenkontaktfläche (50) des Tassenstößels (5), oder die Nockenkontaktfläche (50) und das Tassenhemd (51) des Tassenstößels (5) vollständig oder zumindest teilweise mit einer verschleißfesten Beschichtung nach wenigstens einem der Ansprüche 1 bis 9 ausgebildet ist.

16. Verwendung der Beschichtung nach wenigstens einem der Ansprüche 1 bis 13 als Schicht auf vorbestimmten Flächen von Ventiltriebkomponenten, mechanischen und hydraulischen Tassenstößeln, von Ventilschäften bzw. Ventilschaftauflagen, hydraulischen Abstütz- und Einsteckelementen, Wälzlagerkomponenten, Steuerkolben, insbesondere für Einspritzdüsen im Motorenbereich, von Ausrücklagern, von Kolbenbolzen, von Lagerbuchsen, von Linearführungen oder dergleichen.

17. Verfahren zur Herstellung einer verschleißfesten Beschichtung (3, 4) auf vorbestimmten Flächen (2) von einem reibenden Verschleiß ausgesetzten Maschinenteilen (1) für insbesondere Verbrennungskraftmaschinen, mit folgendem Verfahrensschritt:
Aufbringen mindestens einer nanokristallinen Funktionsschicht (4) aus mindestens zwei CrN$_x$-Phasen auf der vorbestimmten Fläche (2) des Maschinenteils (1) für eine Reibungsreduzierung und für eine Erhöhung des Verschleißwiderstandes der vorbestimmten Fläche (2) des Maschinenteils (1).

18. Verfahren nach Anspruch 17, **dadurch gekennzeichnet, daß** die mindestens eine nanokristalline Funktionsschicht (4) mittels eines PVD-Verfahrens, vorzugsweise mittels eines reaktiven PVD-Sputterverfahrens, auf der vorbestimmten Fläche (2) des Maschinenteils (1) abgeschieden wird.

19. Verfahren nach Anspruch 17 oder 18, **dadurch gekennzeichnet, daß** die mindestens eine Funktionsschicht (4) aus einer metastabilen Mischphase aus überwiegend Cr$_2$N-Bindungen und CrN-Bindungen ausgebildet wird.

20. Verfahren nach wenigstens einem der Ansprüche 17 bis 19, **dadurch gekennzeichnet, daß** die mindestens eine Funktionsschicht (4) mit einem Anteil an Cr$_2$N-Bindungen in der metastabilen Mischphase ausgebildet wird, der mindestens 70% beträgt.

21. Verfahren nach wenigstens einem der Ansprüche 17 bis 20, **dadurch gekennzeichnet, daß** die mindestens eine Funktionsschicht (4) aus mehreren nanokristallinen Einzelschichten aus mindestens zwei $CrN_x$-Phasen ausgebildet wird, wobei die einzelnen Schichten graduell oder in gleich bleibender Schichtzusammensetzung aufgebracht werden.

**22.** Verfahren nach wenigstens einem der Ansprüche 17 bis 21, **dadurch gekennzeichnet, daß** eine Subplantation von Kohlenstoff in die mindestens eine Funktionsschicht (4) durchgeführt wird.

**23.** Verfahren nach wenigstens einem der Ansprüche 17 bis 22, **dadurch gekennzeichnet, daß** zwischen der vorbestimmten Fläche (2) des Maschinenteils (1) und der tetraedrischen amorphen Kohlenstoffschicht (4) mindestens eine Stützschicht (3) und/oder mindestens eine Haftvermittlungsschicht (3) vorgesehen ist, welche beispielsweise mittels eines PVD-Verfahrens als metallhaltige, beispielsweise Wolfram umfassende, Kohlenstoffschicht, als Carbide und/oder Nitride der Übergangsmetalle aufweisende Schicht, mittels einer Wärmebehandlung als einsatzgehärtete, carbonitrierte oder nitrocarburierte Schicht, mittels eines thermochemischen Verfahrens als nitrierte oder borierte Schicht, mittels eines galvanischen Verfahrens als Chrom aufweisende Schicht, beispielsweise als Chromnitridschicht, oder dergleichen ausgebildet wird.

**24.** Verfahren nach wenigstens einem der Ansprüche 17 bis 23, **dadurch gekennzeichnet, daß** vor der Abscheidung die vorbestimmte Fläche (2) des Maschinenteils (1) einsatzgehärtet und/oder carbonitriert und angelassen wird.

**25.** Verfahren nach wenigstens einem der Ansprüche 17 bis 24, **dadurch gekennzeichnet, daß** keine mechanische Nachbearbeitung der mindestens einen abgeschiedenen Funktionsschicht (4) durchgeführt wird.

**26.** Verfahren nach wenigstens einem der Ansprüche 17 bis 25, **dadurch gekennzeichnet, daß** die Abscheidung der mindestens einen Funktionsschicht (4) mit einer Beschichtungstemperatur durchgeführt wird, welche kleiner ist als die Anlasstemperatur des Maschinenteils (1).

**27.** Verfahren nach wenigstens einem der Ansprüche 17 bis 26, **dadurch gekennzeichnet, daß** keine Nachwärmebehandlung der vorbestimmten Fläche (2) des Maschinenteils (1) durchgeführt wird.

Fig. 1

Fig. 2

Fig. 3

Fig. 4

**Europäisches Patentamt**

# EUROPÄISCHER RECHERCHENBERICHT

Nummer der Anmeldung

EP 05 01 7831

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 6 399 219 B1 (WELTY RICHARD P ET AL) 4. Juni 2002 (2002-06-04)<br><br>* Spalte 4, Zeile 7 - Spalte 5, Zeile 33 *<br>----- | 1-7, 10-13, 16-20, 25-27 | C23C14/06 C23C14/00 F01L1/16 |
| X | DE 196 30 149 A1 (KABUSHIKI KAISHA RIKEN, TOKIO/TOKYO, JP; KABUSHIKI KAISHA RIKEN, TOKIO) 30. Januar 1997 (1997-01-30) | 1,2,4,6, 8,10-13, 16-19, 21,23, 25-27 | |
| Y | *Tabelle 1; Beispiel 1; Vergleichsbeispiel 2*<br>* Seite 2, Zeile 42 - Seite 4, Zeile 49 *<br>----- | 14,15,24 | |
| X | DE 199 40 065 A1 (NIPPON PISTON RING CO,. LTD) 2. März 2000 (2000-03-02) | 1,2,4,6, 8,9,12, 13, 16-19, 21,22, 25-27 | |
| Y | * Seite 3, Zeilen 1-19 *<br>----- | 14,15,24 | RECHERCHIERTE SACHGEBIETE (IPC) |
| Y | DE 42 05 647 A1 (INA WÄLZLAGER SCHAEFFLER KG, HERZOGENAURACH, DE) 26. August 1993 (1993-08-26) * Spalte 3, Zeile 48 - Spalte 4, Zeile 41; Anspruch 1; Abbildungen 1,2 *<br>----- | 14,15,24 | C23C F01L |

Der vorliegende Recherchenbericht wurde für alle Patentansprüche erstellt

| Recherchenort | Abschlußdatum der Recherche | Prüfer |
|---|---|---|
| München | 9. Dezember 2005 | Hoyer, W |

EPO FORM 1503 03.82 (P04C03)

**EP 1 634 978 A1**

**ANHANG ZUM EUROPÄISCHEN RECHERCHENBERICHT**
**ÜBER DIE EUROPÄISCHE PATENTANMELDUNG NR.**

EP 05 01 7831

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-12-2005

| Im Recherchenbericht angeführtes Patentdokument | | Datum der Veröffentlichung | Mitglied(er) der Patentfamilie | | Datum der Veröffentlichung |
|---|---|---|---|---|---|
| US 6399219 | B1 | 04-06-2002 | KEINE | | |
| DE 19630149 | A1 | 30-01-1997 | CN | 1154420 A | 16-07-1997 |
| | | | GB | 2303640 A | 26-02-1997 |
| | | | JP | 9031628 A | 04-02-1997 |
| DE 19940065 | A1 | 02-03-2000 | JP | 2000144391 A | 26-05-2000 |
| | | | US | 6232003 B1 | 15-05-2001 |
| DE 4205647 | A1 | 26-08-1993 | WO | 9317146 A1 | 02-09-1993 |
| | | | EP | 0627019 A1 | 07-12-1994 |

Für nähere Einzelheiten zu diesem Anhang : siehe Amtsblatt des Europäischen Patentamts, Nr.12/82